# EUROPEAN PATENT APPLICATION

(11) **EP 2 911 384 A1**
(43) Date of publication of application: **26.08.2015**
(21) Application number: 13851721.4
(22) Date of filing: 28.10.2013
(51) Int. Cl.: H04N 5/369, H01L 27/146

(54) **LINEAR IMAGE SENSOR AND DRIVING METHOD THEREFOR**

(30) Priority: 30.10.2012 JP 2012238850
(71) Applicant: Shimadzu Corporation, Kyoto 604-8511 (JP); Tohoku University, Aoba-ku Sendai-shi Miyagi 980-8577 (JP)
(72) Inventor: TOMINAGA, Hideki, Kyoto-shi Kyoto 604-8511 (JP); HIROSE, Ryuta, Kyoto-shi Kyoto 604-8511 (JP); TAKUBO, Kenji, Kyoto-shi Kyoto 604-8511 (JP); SUGAWA, Shigetoshi, Sendai-shi Miyagi 980-8577 (JP); KURODA, Rihito, Sendai-shi Miyagi 980-8577 (JP)
(74) Representative: Webster, Jeremy Mark
(86) International application number: PCT/JP2013/079111
(87) International publication number: WO 2014/069394

(57) **Abstract**

A logical gate circuit (5) and four stages of flip flips (4a-4d) are assigned to each pixel (1). A controller (7) inputs four phase identification signals into the logical gate circuit (5) and also inputs a start signal STR into a shift register (4) synchronously with the four mutually different phases defined by the phase identification signals. During one round of scanning all the pixels (1) for a readout control, if an enable signal ENBL is set to "0" while an output of a phase identification circuit (110) is "1", a charge accumulation time at the pixel (1) concerned becomes equal to a readout period T. If the enable signal ENBL is set to "1" while the output of the phase identification circuit (110) is "1", electric charges accumulated in a photodiode (11) until that point are entirely discarded, so that the charge accumulation time becomes shorter than the readout period T. Thus, the charge accumulation time at each pixel (1) can be controlled to ensure an adequate SN ratio while avoiding signal saturation at some pixels even if the light source has a bright line at a specific wavelength.

## Description

### TECHNICAL FIELD

The present invention relates to a linear image sensor consisting of a plurality of photoelectric conversion elements arrayed in a one-dimensional form, as well as a method for driving such a sensor. In particular, it relates to a linear image sensor suitable for detecting light dispersed into wavelengths in a spectrometric device, such as a spectrophotometer or fluorescence analyzer, along with a method for driving such a sensor.

### BACKGROUND ART

In a spectrometric device, such an ultraviolet-visible spectrophotometer or a spectroscopic detector for a liquid chromatograph, a linear image sensor having a large number (e.g. from 128 to 1024 pieces) of one-dimensionally arrayed photodiodes made of silicon (Si), indium gallium arsenide (InGaAs) or other semiconductors as the base material, is used for simultaneous detection of light dispersed into wavelengths by a light-dispersing device. Linear image sensors are roughly divided into the CCD type and CMOS type. In recent years, the CMOS type has become mainstream due to easy integration with surrounding circuits, low power consumption and other advantages.

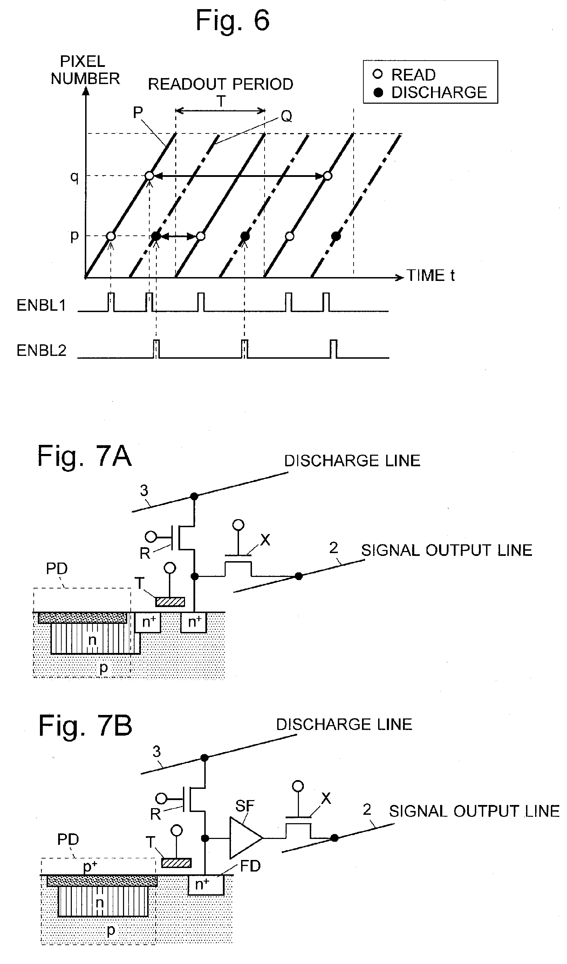

Linear CMOS image sensors are divided into a charge-readout type and voltage-readout type according to their difference in the signal-readout method. Fig. 7A shows an example of the schematic configuration of one pixel in a commonly used charge-readout type linear CMOS image sensor, and Fig. 7B shows an example of the schematic configuration of one pixel in a commonly used voltage-readout type linear CMOS image sensor.

As shown in Fig. 7A, in the case of the charge-readout type linear CMOS image sensor, one pixel normally includes a photodiode PD as a photoelectric conversion element, a selection switch X for connecting the photodiode PD to a signal output line 2 (which is external to the pixel and common to all the pixels), and a reset switch R for connecting the photodiode PD to a discharge line 3 (which is external to the pixel and common to all the pixels). A plurality of pixels having such a structure are linearly arranged to form the sensor. When light falls onto the sensor, photocharges are produced and accumulate in the photodiode PD receiving the incident light. The resulting charge signal is read through the transfer gate T and the selection switch X to the signal output line 2.

By contrast, in the case of the voltage-readout type linear CMOS image sensor, as shown in Fig. 7B, one pixel normally includes a floating diffusion FD for converting photocharges into a voltage signal and a source follower amplifier SF for amplifying the voltage signal, in addition to the photodiode PD, transfer gate T, selection switch X and reset switch R. When light falls onto the sensor, photocharges are produced and accumulate in the photodiode PD receiving the incident light. Then, when the transfer gate T is opened, the electric charges flow into the floating diffusion FD, which converts the electric charges into a voltage signal corresponding to the amount of charges. This voltage signal is amplified by the source follower amplifier SF and read through the selection switch X to the signal output line 2. The source follower amplifier SF provided in the example of Fig. 7B is optional.

In both cases of the charge-readout type illustrated in Fig. 7A and the voltage-readout type illustrated in Fig. 7B, when the charge signal produced by the photodiode PD or similar photoelectric conversion element inside the pixel, or the voltage signal based on that charge signal is to be extracted from the pixel to the external signal output line 2, it is necessary to simultaneously open the transfer gate T and the selection switch X. Furthermore, when the signal charges which have accumulated in the photodiode PD or floating diffusion FD are to be drained through the discharge line 3 to the outside of the element without being extracted to the signal output line 2, it is necessary to simultaneously open the transfer gate T and the reset switch R.

For ease of explanation, the operation of simultaneously opening the transfer gate T and the selection switch X to form a signal path from the photodiode PD to the signal output line 2 is represented by a single switch, which is hereinafter called the "readout switch." Similarly, the operation of simultaneously opening the transfer gate T and the reset switch R to form a signal path from the photodiode PD to the discharge line 3 is represented by a single switch, which is hereinafter called the "discharge switch." Furthermore, in the following descriptions using the circuit diagrams, for convenience, it is assumed that there are two logical switches to be operated, i.e. the readout switch and the discharge switch. Needless to say, an actual implementation of those circuits will require additional circuit elements for operating the transfer gate T, selection switch X and reset switch R.

In both the charge-readout and voltage-readout types of linear CMOS image sensors, the readout switch in each pixel is sequentially turned on for a preset period of time by a drive signal from an address scan circuit, such as a shift register. During the ON period, the charge or voltage signal is extracted to the common signal output line 2. In a common type of linear image sensor, all the pixels have their respective readout switches turned on once within each readout period, which equals the reciprocal of the frame rate. Each pixel is operated as follows: In the case of the charge-readout type, when the readout switch is turned on to read the charge signal, the electric charges accumulated in the photodiode are reset. In the case of the voltage-readout type, after the readout switch is turned on for a preset period of time to read the voltage signal, the discharge switch is turned on for a preset period of time to reset the electric charges accumulated in the photodiode or the potential of the floating diffusion and thereby make the pixel ready for charge accumulation for the next readout period. Accordingly, in commonly used linear CMOS image sensors, the charge accumulation time in each pixel is approximately equal to the readout period.

However, having the readout period thus being equal to the charge accumulation time may cause a problem. For example, when a linear CMOS image sensor is used as a photodetector in a spectrometric device, the intensity of light arriving at the sensor significantly varies depending on the situation, such as whether or not a sample to be subjected to the measurement is set. If the readout period is always equal to the charge accumulation time, the photodiode will be saturated with accumulated charges when the light intensity is high, making it impossible to obtain the correct value of the signal. Such a signal saturation can be avoided, for example, by providing an attenuator for reducing the strength of the incident light to the sensor. However, this causes the problem that the SN ratio of the signal will be insufficient when the light intensity is low. In principle, it may be possible to adaptively change the readout period so as to optimize the charge accumulation time according to the intensity of the incident light. However, due to hardware restrictions, such an operation is actually difficult; for example, the readout period is limited by the frequency response of the sensor, and the frequency characteristics of the readout circuit external to the sensor cannot be easily changed. Decreasing the readout period is particularly difficult.

On the other hand, in the field of two-dimensional CMOS image sensors, there is a sensor having an electronic shutter function for appropriately discarding the already accumulated charges in the middle of the charge accumulation period to effectively reduce the charge accumulation time (see Patent Literature 1).

That is to say, in the case of a normal voltage-readout CMOS image sensor, after one horizontal line from which signals are to be read is selected with the row selection shift register, the pixels belonging to that horizontal line are sequentially scanned with the column selection shift register to read the respective pixel signals. In this case, the charge accumulation time is also approximately equal to the readout period, since the discharging (or resetting) operation is performed after the horizontal line is selected through the row selection shift register and the voltage signals are read from the pixels through the column selection shift register. By contrast, the CMOS image sensor described in Patent Literature 1 is provided with two row selection shift registers which are independently assigned to the readout switch and the discharge switch, respectively. After one horizontal line is selected and electric charges are drained electric charges from this line by the discharge shift register, a specific length of delay time shorter than the readout time is provided, after which the horizontal line is once more selected through the readout shift register to read signals. According to this operation, the charge accumulation time is equal to the operation delay time between the two shift registers, and a charge accumulation time shorter than the readout period can be realized.

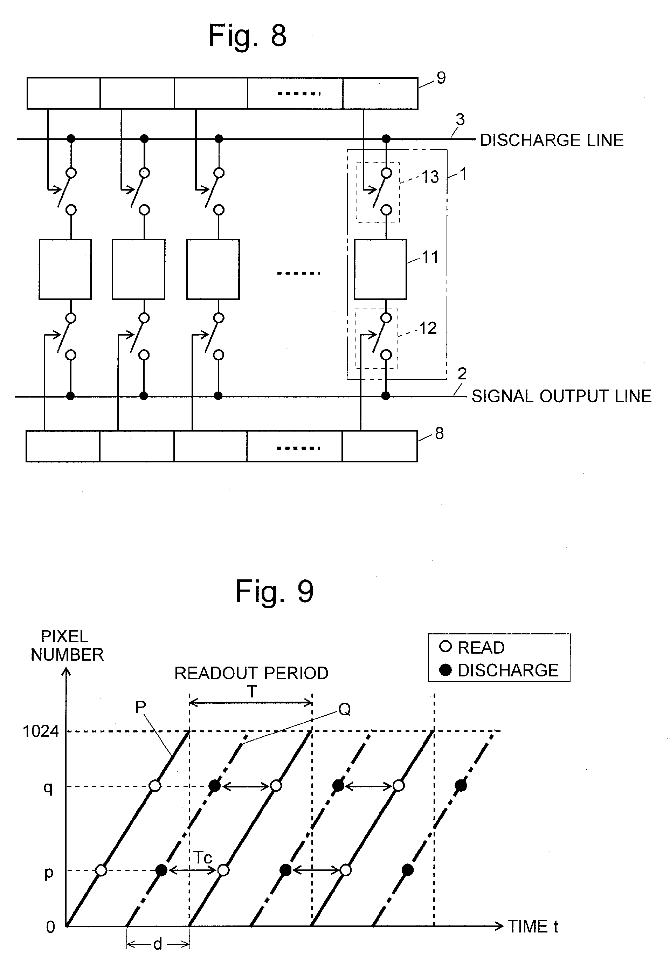

The technique described in Patent Literature 1 is naturally applicable in a linear CMOS image sensor. To put it another way, the charge accumulation time at each pixel in a linear CMOS image sensor can also be set at a length shorter than the readout period by similarly using the readout and discharge shift registers. Fig. 8 is a schematic configuration diagram of a linear CMOS image sensor in which the technique described in Patent Literature 1 is applied, and Fig. 9 is a model diagram for explaining the method for controlling the charge accumulation time in the configuration shown in Fig. 8.

In Fig. 8, each of a large number of pixels 1 (in the present example, 1024 pieces) horizontally arranged in a row includes: one photodiode 11; one readout switch 12 for connecting the photodiode 11 and the common signal output line 2; and one discharge switch 13 for connecting the photodiode 11 and a common discharge line 3. The readout switch 12 in each pixel 1 is turned on and off by a signal supplied from a readout shift register 8, while the discharge switch 13 is turned on and off by a signal supplied from a discharge shift register 9. It should be noted that the internal configuration of the individual pixels 1 is shown in a simplified form, which can actually have a configuration similar to Fig. 7A or 7B.

Each of the readout and discharge shift registers 8 and 9 consists of serially connected flip flops forming the same number of stages as the pixels. Each of these resisters produces a signal value for sequentially turning on the switches 12 or 13 of the pixels based on an independent start signal and a common clock signal.

In Fig. 9, the horizontal axis represents time and the vertical axis represents the serial number (pixel number) assigned to the 1024 pixels. The upward-inclined solid lines P indicate the pixel designated by the readout shift register 8 as the target of the readout operation. Similarly, the upward-inclined chain lines Q in the figure indicate the pixel designated by the discharge shift register 9 as the target of the discharging operation. For example, at the two pixels with pixel numbers p and q, the signal-readout operation through the readout switch 12 is performed at the points in time indicated by the white circles on the solid lines P, while the discharging operation through the discharge switch 13 is performed at the points in time indicated by the filled circles on the chain lines Q.

Now, with the focus on the pixel with pixel number p, the time interval between any two white circles horizontally adjacent to each other corresponds to the readout period T, with a filled circle in between. At the point of this filled circle, the charges accumulated in the pixel are entirely drained and the charge accumulation once more begins from the reset state. Accordingly, the effective charge accumulation time at this pixel is the interval of time between the filled circle and the white circle on the right side, Tc, which is shorter than T. As is evident from Fig. 9, Tc is equal to the operation delay time d of the two shift registers 8 and 9. This operation delay time d is determined by the two start signals respectively given to the two shift registers 8 and 9.

In general, to obtain signals with high SN ratios in an optical measurement, the amount of charges produced in the photodiode in each pixel of the linear image sensor should preferably be as high as possible within a range that does not exceed the signal saturation level. However, many light sources used in spectrometry, such as the deuterium lamp, emit strong bright lines at specific wavelengths. When such light is dispersed into wavelengths and detected with a linear image sensor, one or a small number of pixels which receive a bright line will be illuminated with extremely stronger light than the other pixels. Therefore, to obtain high amounts of charges that ensure adequately high SN ratios at both the pixels which receive bright lines and the other pixels, it is necessary to set an extremely short charge accumulation time for specific pixels which receive bright lines and to set an adequately long charge accumulation time for the other pixels.

However, with the technique described in the aforementioned Patent Literature 1, although it is possible to set a charge accumulation time extremely shorter than the readout time T for all the pixels, it is impossible to set a different charge accumulation time for each horizontal line or for each pixel. Therefore, while it is possible to set an extremely short charge accumulation time common to all the pixels to prevent saturation at the pixels which receive bright lines, this setting prevents the other pixels which do not receive any bright line from producing sufficient amounts of charges, thus causing a deterioration in the SN ratio of the signal.

Patent Literature 2 discloses a method in which the operation of reading a signal from each pixel is not always performed at specified intervals of time; instead, the function of determining, for each pixel, whether or not the readout operation should be omitted at that pixel is provided so that the charge accumulation time at any specific pixel can be increased to an integer multiple of the readout period by appropriately omitting the readout operation at that specific pixel. Although this method allows the setting of a charge accumulation time longer than the readout period at an arbitrary pixel, it does not allow the opposite, i.e. the setting of a charge accumulation time shorter than the readout period at an arbitrary pixel. Therefore, while the charge accumulation time at pixels which do not receive bright lines can be exclusively increased to ensure adequate amounts of charges at all the pixels, it is difficult to avoid saturation of the pixels receiving the bright lines since the charge accumulation time cannot be shorter than the readout period. In principle, the saturation of the pixels receiving the bright lines could be avoided by shortening the readout period. However, directly shortening the readout period is impractical due to the earlier mentioned hardware restrictions.

### CITATION LIST

### PATENT LITERATURE

Patent Literature 1: JP 05-227489 A
Patent Literature 2: JP 2006-349623 A

### SUMMARY OF INVENTION

### TECHNICAL PROBLEM

As described previously, when a linear image sensor is used as a photodetector for spectrometry, and when the light source has a bright line at a specific wavelength, the conventional techniques may possibly allow some pixels to inevitably reach signal saturation or prevent other pixels from accumulating a necessary amount of charges for obtaining an adequate SN ratio.

The present invention has been developed in view of such a problem, and its objective is to provide a linear image sensor and its driving method in which the light signal generated in any pixel can be prevented from saturation, and in which the amount of signal close to the saturation level can be obtained at any pixel which receives low-intensity light, even in the case where the wavelength-intensity distribution of the light source includes a bright line or similar wavelength at which the light intensity is extremely high as compared to the other wavelength regions.

### SOLUTION TO PROBLEM

A linear image sensor according to the present invention aimed at solving the previously described problem includes:
a) N pixels arrayed in a one-dimensional form, each pixel having: a signal-generating section including a photoelectric conversion element; a readout switch provided for the signal-generating section between the signal-generating section and a signal output line which will be mentioned later; and a discharge switch provided for the signal-generating section between the signal-generating section and a discharge line which will be mentioned later;
b) a signal output line common to all the pixels, for extracting signals obtained in the N pixels;
c) a discharge line for discarding electric charges obtained in the N pixels; and
d) a drive controller for commanding an operation of temporarily turning on the readout switch and an operation of temporarily turning on the discharge switch, these two operations being commanded for each pixel and independently from each other, the drive controller turning on the readout switches of the pixels during mutually different periods of time and commanding the turning on/off of the readout switch and the discharge switch of each pixel after determining, for each pixel, whether or not the discharge switch in the pixel should be turned on, or specifying, for each pixel, a timing of turning on the discharge switch in the pixel, within the period of time from a point of turning on the readout switch at the pixel concerned to the next point of turning on the same readout switch.

In a typical and preferable form of the linear image sensor according to the present invention, the drive controller commands the turning on/off of the readout switch and the discharge switch of each pixel in such a manner that, within a predetermined readout period, the readout switches in the N pixels are sequentially turned on, once for each pixel, while the discharge switches in at least some of the pixels are temporarily turned on in a predetermined order.

In the linear image sensor according to the present invention, the photoelectric conversion element is normally a photodiode. The signal-generating section may consist of only a photodiode, or it may additionally include a floating diffusion for converting the amount of charges into a voltage signal, a transfer gate for transferring the accumulated charges from the photodiode to the floating diffusion, and other components. The signal output line is a line for serially reading charge signals or voltage signals from the pixels and is common to all the pixels, while the discharge line is a line for removing unnecessary charges to the outside of a semiconductor substrate or other areas and does not need to be common to all the pixels.

As described earlier, in the linear image sensor according to the present invention, the drive controller typically outputs command values to turn on the readout switches of all the pixels sequentially and at predetermined intervals of time. In this case, the charge or voltage signal is read from each pixel through the readout switch to the output signal line, once for each pixel, within a predetermined readout period T. If the discharge switches were not turned on at all, every pixel would have the same charge accumulation time. By contrast, the drive controller in the present invention issues commands to turn on the discharge switch in any one or more pixels among the entire group of pixels.

The period of time from a point when the readout switch was turned off in one pixel to the next point when the same readout switch is turned off is the charge accumulation period for accumulating photocharges generated in the photoelectric conversion element by incident light. If the discharge switch is turned on in the middle of this period, the charges accumulated until that point are entirely drained, so that the charge accumulation period is effectively reduced. Accordingly, the specific pixel in which the discharge switch has been turned on has a shorter charge accumulation time than a pixel in which the discharge switch has not been turned on. Therefore, for example, the accumulated charges in that specific pixel are less likely to reach the saturation level even if the light intensity is high.

In the previously described example, when the discharge switch is turned on in the middle of the period of time from a point when the readout switch was turned off to the next point when the same readout switch is turned off, the length of the effective charge accumulation period in the pixel concerned depends on the time delay from the point in time where the readout switch is turned off after a predetermined length of time is elapsed from its turning on, to the point in time where the discharge switch is turned off after a predetermined length of time is elapsed from its turning on. By changing the timing of turning on the discharge switch so as to vary this delay time, it is possible to change the length of the effective charge accumulation period for each pixel. In other words, it is possible not only to give a specific pixel or pixels a charge accumulation period shorter than the charge accumulation period determined by the readout period, but also to select, for each pixel, one of a plurality of mutually different lengths of the charge accumulation period.

Naturally, in the linear image sensor according to the present invention, the command to turn on the readout switch is also issued for each pixel. Therefore, similarly to Patent Literature 2, it is possible to additionally perform a control for increasing the readout operation at any specific pixel by appropriately omitting the readout operation at that pixel. This effectively eliminates the upper limit of the length of the charge accumulation period and provides higher degrees of freedom for setting the charge accumulation period.

As one mode of the specific configuration in the linear image sensor according to the present invention, the drive controller may have a configuration including: at least one address scan circuit for selecting each pixel or the readout switch and the discharge switch in each pixel; and N logical gate circuits provided for the N pixels, respectively, with each logical gate circuit allowing or preventing the passage of a command value from the address scan circuit according to an enable signal.

Similarly to normal linear image sensors, the address scan circuit can be realized using a shift register. The use of a shift register ensures that the pixels will be sequentially selected, and it also reduces the circuit scale. When a shift register is used as the address scan circuit, either a configuration having an increased number of stages instead of an increased number of shift registers (serial configuration) or a configuration having an increased number of shift registers instead of an increased number of stages per one shift register (parallel configuration) can be adopted to output a plurality of command values for adjusting the charge accumulation period for each pixel.

Thus, in the first mode of the linear image sensor according to the present invention:
the address scan circuit includes one M×N-stage shift register (where M is an integer equal to or greater than two) which completes the scan of all stages within a predetermined readout period T;
the logical gate circuit provided for each of the N pixels receives, as inputs, an output from one stage of the M×N-stage shift register, the enable signal, and M pieces of phase identification signals;
the logical gate circuit includes:
   a phase identification circuit with a plurality of outputs, for finding a phase at which the output of the shift register is valid among M phases defined by the M pieces of phase identification signals, and for outputting a valid value only at each phase found;
   a first gate circuit for receiving, as inputs, one output of the phase identification circuit and the enable signal, and for allowing the passage of the value received from the phase identification circuit when the enable signal has a valid value; and
   a second gate circuit for receiving, as inputs, outputs of the phase identification circuit exclusive of the aforementioned one output and the enable signal, and for allowing the passage of the outputs of the phase identification circuit corresponding to the M-1 phases exclusive of the signal of the phase sent to the first gate circuit when the enable signal has a valid value; and
each pixel is configured so that the output of the first gate circuit drives the readout switch of the pixel while the output of the second gate circuit drives the discharge switch of the pixel.

For example, in the case where the command value for turning on the readout switch or the discharge switch is a high-level voltage value corresponding to a logical "1", the valid value of the enable signal is also a high-level voltage value corresponding to the logical "1", and both the first and second gate circuits can be an AND gate circuit.

A preferable method for driving the linear image sensor according to the first mode includes:
inputting a clock signal with a period Δt equal to T/(M+N) and a start signal for initiating a scan into the M×N-stage shift register; and
inputting the start signal M times during the readout period T, the M start signals having different delay times and respectively synchronized with different phases #m, where a phase #m represents a period of length Δt during which the m-th phase identification signal (m=1, ..., M) is providing a valid value with the period of length Δt among the M phase identification signals continuously generated for any one of the N pixels, with one phase identification signal generated for each pulse of the clock signal.

In this case, one of the M start signals is used to perform a scan for sequentially turning on the readout switches of the pixels, while the other M-1 start signals are used to perform a scan for sequentially turning on the discharge switches of the pixels. However, even when the command value outputted from a phase identification circuit assigned to a pixel has become the command value for turning on the readout or discharge switch, whether or not the switch actually turns on depends on the level of the enable signal. Accordingly, it is possible to turn on the discharge switch of any pixel with a timing corresponding to the delay time of the start signal during the readout period T. This enables the actual charge accumulation time to be shorter than the charge accumulation time approximately equal to the readout period T by an amount corresponding to the delay time. For example, if M has a value of 4, there are three possible choices of the delay time for the removal of electric charges and hence three possible choices of the charge accumulation time shorter than the readout period T.

In the second mode of the linear image sensor according to the present invention:
the address scan circuit includes M pieces of N-stage shift registers (where M is an integer equal to or greater than two) which complete the scan of all stages corresponding to the N pixels within a predetermined readout period T;
the logical gate circuit provided for each of the N pixels includes M gate circuits, with each of the M gate circuits receiving, as inputs, an output from one stage of one N-stage shift register among the M pieces of the N-stage shift registers and the enable signal, and allowing the passage of the value of the input different from the enable signal when the enable signal has a valid value; and
each pixel is configured so that L outputs among the outputs of the M gate circuits (where L is an integer equal to or greater one and equal to or less than M) drive the readout switch of the pixel while the remaining M-L outputs drive the discharge switch of the pixel.

For example, in the case where the command value for turning on the readout switch or the discharge switch is a high-level voltage value corresponding to a logical "1", the valid value of the enable signal is also a high-level voltage value corresponding to the logical "1", and all the M gate circuits may be an AND gate.

A preferable method for driving the linear image sensor according to the second mode includes:
inputting a common clock signal with a period Δt equal to T/N into all the M shift registers and inputting a start signal for initiating a scan of each shift register into each of the M shift registers,
where at least one of the M start signals is inputted with a timing different from the other start signals.

This mode of operation will be similar to the first mode if the M start signals which are inputted into one shift register during the readout period T in the first mode are respectively inputted into the M shift registers, with one signal for each shift register. The second mode requires more complex wiring than the first mode but allows the use of a clock signal with a shorter period.

### ADVANTAGEOUS EFFECTS OF THE INVENTION

In the linear image sensor and its driving method according to the present invention, it is possible to dramatically shorten the charge accumulation time in an arbitrary number of pixels located at arbitrary positions among the entire group of N pixels as compared to the other pixels. Therefore, when the linear image sensor according to the present invention is used as a detector for a spectrometric device, even if the wavelength-intensity distribution of the light source includes a bright line or similar wavelength at which the light intensity is extremely high as compared to the other wavelength regions, it is possible to prevent one or more pixels receiving the bright line from being saturated with photocharges, while ensuring an adequately long charge accumulation time at any pixel receiving low-intensity light so that the amount of accumulated signals will be close to the saturation level. As a result, high SN ratios can assuredly be achieved at all the pixels without causing signal saturation.

### BRIEF DESCRIPTION OF DRAWINGS

Fig. 1 is a configuration diagram showing the main components of a linear image sensor as the first embodiment of the present invention.
Fig. 2 is a model diagram illustrating a driving method for controlling the charge accumulation time in the linear image sensor of the first embodiment.
Fig. 3 is a sectional view showing a schematic structure of one pixel in the linear image sensor of the first embodiment.
Fig. 4 is a schematic configuration diagram of a spectrophotometer using the linear image sensor of the first embodiment.
Fig. 5 is a configuration diagram showing the main components of a linear image sensor as the second embodiment of the present invention.
Fig. 6 is a model diagram illustrating a driving method for controlling the charge accumulation time in the linear image sensor of the second embodiment.
Fig. 7A shows one example of the schematic configuration of one pixel in a commonly used charge-readout type linear CMOS image sensor, and Fig. 7B shows one example of the schematic configuration of one pixel in a commonly used voltage-readout type linear CMOS image sensor.
Fig. 8 is a configuration diagram showing the main components of a linear image sensor in which a conventional technique for controlling the charge accumulation time is applied.
Fig. 9 is a model diagram illustrating a driving method for controlling the charge accumulation time in the configuration shown in Fig. 8.

### DESCRIPTION OF EMBODIMENTS

### [First Embodiment]

An embodiment (first embodiment) of the linear image sensor and its driving method according to the present invention is hereinafter described with reference to the attached drawings.

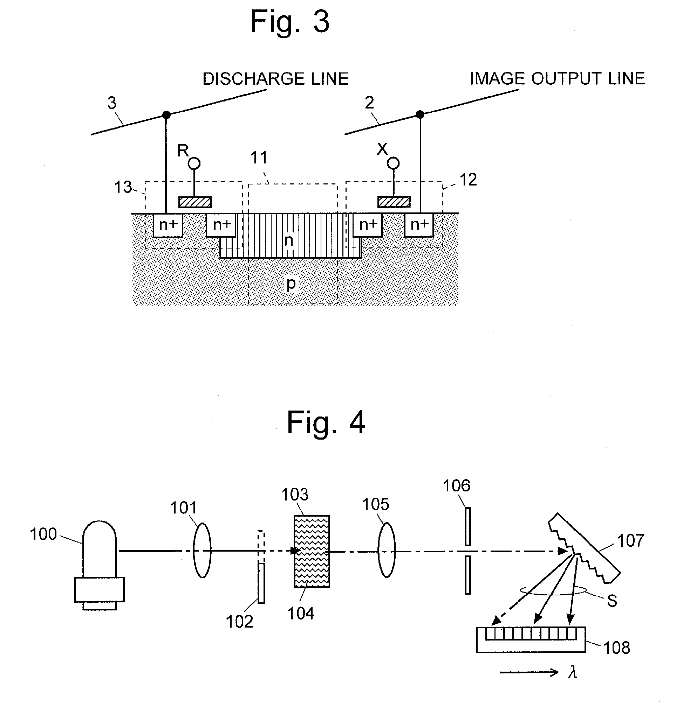

The linear image sensor of the first embodiment (and that of the second embodiment, which will be described later) is suitable as a detector for a spectrophotometer as shown in Fig. 4. Measurement light emitted from the bright point in a light source 100 having a specific emission spectrum (e.g. a deuterium lamp, tungsten lamp or xenon lamp) is focused by a lens 101 and cast into a sample cell 103 made of quartz glass or a similar transparent material with a liquid sample 104 held inside. After passing through the liquid sample 104, the transmitted light is focused by a lens 105 and falls onto a light-dispersing device 107 (e.g. a diffraction grating) through a slit 106. The transmitted light is dispersed into wavelengths in a one-dimensional direction by the light-dispersing device 107. The wavelength-dispersed light S reaches the linear image sensor 108.

Since the positional relationship between the light-dispersing element 107 and the linear image sensor 108 is always the same, each of the pixels forming the linear image sensor 108 receives a fixed wavelength range of the wavelength-dispersed light S within a fixed range of incident angle. Typically, the wavelength range of the light falling onto the linear image sensor 108 is approximately 200 nm to 1100 nm. Each pixel of the linear image sensor 108 produces a detection signal corresponding to the intensity (amount) of the incident light. A blank measurement with no incident light can be performed by blocking the measurement light by closing a shutter 102 located between the lens 101 and the sample cell 103. The light-dispersing element 107 shown in Fig. 4 as one example is a concave reflection grating and has the additional function of forming an image of the slit 106 on the light-receiving surface of the linear image sensor 108. In some cases, a lens, mirror or similar optical element having such an image-forming function may be provided separately from the light-dispersing element 107.

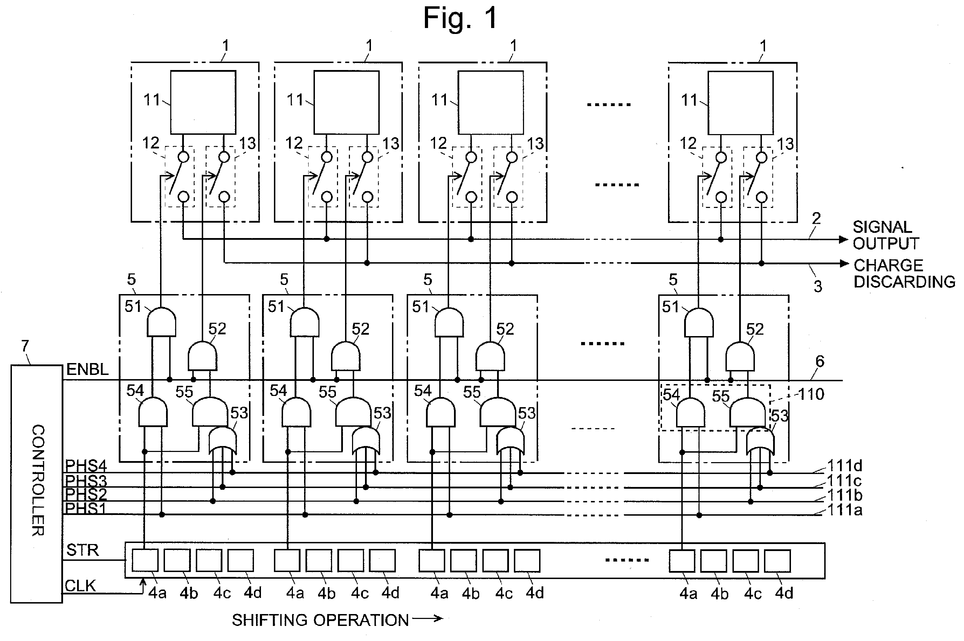

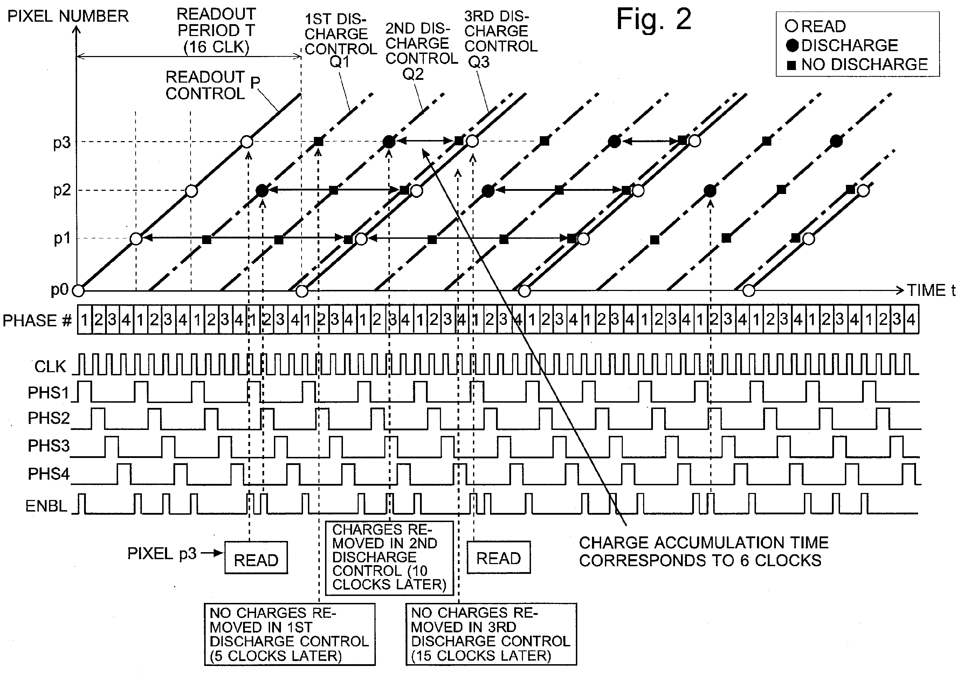

Fig. 1 is a configuration diagram showing the main components of the linear image sensor according to the first embodiment, Fig. 2 is a model diagram illustrating a driving method for controlling the charge accumulation time in the linear image sensor of the first embodiment, and Fig. 3 is a sectional view showing a schematic structure of one pixel in the linear image sensor of the first embodiment. The pixel structure shown in Fig. 3 is an example of the charge-readout type and is the simplest configuration which has no transfer gate T. As far as this configuration is concerned, the logical readout switch is identical to the selection switch X, and the discharge switch is identical to the reset switch R. This structure tends to require complex design of the potential profile for quickly gathering electric charges into the area under the selection switch or the reset switch, since the charge transfer direction is reversed between the readout phase and the discharge phase. Accordingly, it is common practice to adopt a structure with a transfer gate T added as shown in Fig. 7A, so as to transfer electric charges always in the same direction. Although the pixel structure shown in Fig. 3 is presently used for ease of explanation, it should be naturally understood that the following description also holds true in the case where the structure is replaced with Fig. 7A or 7B.

The linear image sensor of the first embodiment consists of N pieces (in the present example, 1024 pieces) of pixels 1 arrayed in a one-dimensional direction, with each pixel including one photodiode 11. In addition to the photodiode 11, each pixel 1 includes one readout switch 12 located between the photodiode 11 and a signal output line 2 which is common to all the pixels, and a discharge switch 13 located between the photodiode 11 and a discharge line 3 which is also common to all the pixels. Both the readout switch 12 and the discharge switch 13 consist of a MOSFET, which turns on or off the connection between the photodiode 11 and a line (signal output line 2 or discharge line 3) according to the amount of voltage applied to its gate electrode.

The drive control circuit for independently turning on/off the readout switch 12 and the discharge switch 13 of each pixel 1 includes: a shift register 4 consisting of 4xN (in the present example, 4×1024=4096) stages of flip flops; N sets of logical gate circuits 5, one set for each pixel 1; and a controller 7 for giving control signals to the shift register 4 and each logical gate circuit 5. The controller 7 may be integrated with the linear image sensor on the same semiconductor substrate, or it may be provided separately from the sensor.

As shown in Fig. 1, the shift register 4 has four-stage flip flops 4a, 4b, 4c and 4d serially connected as one set, with one set of flip flops 4a-4d assigned to each pixel 1. The flip flop 4a outputs a command signal for turning on the readout switch 12 or discharge switch 13 in each pixel 1 for a preset period of time, sequentially from the leftmost pixel 1, based on the start signal STR and the clock signal CLK fed from the controller 7.

One logical gate circuit 5 includes two AND gates 51 and 52, two AND gates 54 and 55 forming a phase identification circuit 110, as well as one three-input OR gate 53. The two AND gates 51 and 52 each have one input terminal connected to a common enable signal line 6 through which an enable signal ENBL is supplied from the controller 7. The first AND gate 51, which supplies a drive signal to the readout switch 12, has the other input terminal connected to the output of the first-stage flip flop 4a in one set of the shift register 4 via the AND gate 54. Similarly, the second AND gate 52, which supplies a drive signal to the discharge switch 13, has the other input terminal is connected to the output of the flip flop 4a via the AND gate 55. A signal line 111a for supplying a phase identification signal PHS1 is connected to the other input terminal of the AND gate 54 which is not connected to any flip flop, while three signal lines 111b, 111c and 111d for respectively supplying phase identification signals PHS2, PHS3 and PHS4 via the output terminal of the three-input OR gate 53 are connected to the other input terminal of the AND gate 53. By this system, among the four phases #1, #2, #3 and #4 which are respectively defined by the valid periods of the four phase identification signals PHS1, PHS2, PHS3 and PHS4, phase #1 is assigned for the scan of the readout switch 12 while the other three phases are assigned for the scan of the discharge switch 13. According to the configuration of the present embodiment, the switch 12 or 13 is in the ON state when the drive signal is at a high-level voltage value (logical "1") and in the OFF state when the drive signal at a low-level voltage value (logical "0"). Naturally, these configurations do not constitute limiting factors.

More specifically, the clock signal CLK is a pulse signal with a fixed period as shown in Fig. 2 (which will be described later). At every rise of the clock signal CLK (i.e. every time one clock of the clock signal CLK is inputted), the shift register 4 shifts the signal (logical "1" or "0") held in a flip flop in the previous stage (e.g. 4a) to the flip flop in the next stage (e.g. 4b). To define phases #1- #4 for every four successive pulses of the clock signal CLK, phase identification signals PHS1-PHS4 as shown in Fig. 2 are generated by the controller 7. Accordingly, four timings for controlling the state of the flip flop 4a are realized in each pixel as the phase changes from #1 through #4. In the present embodiment, the four phases labelled as #1-#4 are respectively assigned to the timings of the readout control, first discharge control, second discharge control and third discharge control (which will be described later).

Normally, the operation of selecting one pixel after another and reading a signal from each pixel is achieved by inputting a start signal into the shift register synchronously with the readout period T. By contrast, in the present embodiment, the start signal STR is inputted four times into the shift register 4 at different timings during the scan process by the shift register 4 in order to drain electric charges in the middle of the readout period T. The first start signal is inputted synchronously with phase #1, indicating the start point of the readout control. The next start signal is inputted synchronously with phase #2 after a fixed amount of delay time is elapsed from the aforementioned start signal for the readout control, indicating the start point of the first discharge control. The two subsequent start signals are respectively inputted synchronously with phases #3 and #4, indicating the start points of the second and third discharge controls. When the start signal STR is inputted into the shift register 4, the output of the first-stage flip flop (the leftmost one in Fig. 1) is set to the logical "1", i.e. the command value for turning on the switches 12 and 13. The value thus set in response to the start signal is shifted to the subsequent flip flop at every single clock of the clock signal CLK.

Meanwhile, the logical gate circuit 5 limits the ON state of the readout switch 12 and the discharge switch 13 of each pixel 1 by allowing or blocking each output value of the phase identification circuits 110 according to the enable signal ENBL. That is to say, when a signal value for turning on the switches 12 and 13 is outputted from the phase identification circuit 110, if the enable signal ENBL is simultaneously set to the high-level voltage value, the output value of the shift register 4 is directly transmitted to the switches 12 and 13, causing these switches 12 and 13 to turn on. Otherwise, i.e. if the enable signal ENBL is at the low-level voltage value, the output value of the shift register 4 does not reach the pixel 1 and the switches 12 and 13 remain in the OFF state.

When the logical "1" outputted from the phase identification circuit 110 reaches the readout switch 12 as a result of setting the enable signal ENBL to the high level, the photodiode 11 is connected to the signal output line 2, so that the signal charges accumulated until that point are entirely read to the signal output line 2. On the other hand, when the logical "1" outputted from the shift register 4 reaches the discharge switch 13 as a result of setting the enable signal ENBL to the high level, the photodiode 11 is connected to the discharge line 3, so that the electric charges accumulated until that point are entirely drained through the discharge line 3 to the outside.

The reason for using phases #2-#4 for controlling the discharge switch 13 in the present embodiment is to allow the setting of three different lengths of charge accumulation times shorter than the readout time T in addition to the default value of the charge accumulation time which is equal to the readout period T, so as to optimize the charge accumulation time for each pixel 1 so that every pixel will produce approximately the same amount of electric charges. Accordingly, if it is necessary to provide only one choice of the charge accumulation time shorter than the readout period T, only one phase needs to be allotted for the control of the discharge switch 13. In this case, only two phases inclusive of the readout control need to be provided, so that only two stages of flip flops need to be provided per pixel. Conversely, increasing the number of stages of the flip flops and the phases that can be assigned to each pixel 1 allows a greater number of values to be set as the length of the charge accumulation time. For example, setting seven different phases for the control of one discharge switch 13 allows the setting of seven different lengths of the charge accumulation time shorter than the readout period T. However, increasing the number of stages of the shift register and that of the phases leads to a corresponding increase in the scale of the circuit. Furthermore, a corresponding increase in the frequency of the clock signal CLK supplied to the shift register 4 is also required if it is necessary to realize a readout period T approximately equal to the readout period used before the increase in the number of stages. Given these factors, it is practically appropriate to allot three to seven flip flops for the scan of one discharge switch 13.

Next, the method for controlling the charge accumulation time in the linear image sensor of the first embodiment is described in detail using Fig. 2. Fig. 2 is an operation timing chart which shows, for ease of explanation, a simplified case where the number N of pixels is four (each pixel 1 having a pixel number of p0, p1, p2 or p3). Though not shown in this figure, a start signal for the first discharge control as indicated by Q1 is given after a total of 4+1=5 clocks of clock signals CLK have been inputted since the point when a start signal for the readout operation was given from the controller 7 to the shift register 4. Then, after a total of 2x4+2=10 clocks of clock signals CLK have been inputted, a start signal for the second discharge control as indicated by Q2 is given. Similarly, after a total of 3x4+3=15 clocks of clock signals CLK have been inputted, a start signal for the third discharge control as indicated by Q3 is given. Thus, the three start signals for the discharging operation are given to the shift register 4 at different points in time delayed from the readout start signal by their respective predetermined amounts of time.

In the present example, since the number N of pixels is four and there are four stages of flip flops per pixel, the length of time required for the shift register 4 to make a round of scanning all the pixels 1, i.e. the readout period T, is equal to the interval of the points in time at which the readout switch 12 is turned on; this length corresponds to 16 clocks of the clock signal CLK. In this case, the readout period T corresponds to the maximum value of the charge accumulation time. The charge accumulation time in a pixel will be the maximum if the discharge switch 13 in that pixel is not turned on within the period of time from the point where the readout switch 12 of that pixel is turned on to read the charge signal and then turned off, to the point where the same readout switch 12 is turned on the next time (i.e. after one round of scanning the pixels is completed) to read the charge signal. On the other hand, at a pixel where the discharging operation is performed at the timing which accords with the first discharge control having the smallest amount of delay from the readout point, the charge accumulation time will be equivalent to 16-5=11 clocks. Similarly, at a pixel where the discharging operation is performed at the timing which accords with the second discharge control having the second smallest amount of delay, the charge accumulation time will be equivalent to 16-10=6 clocks. The charge accumulation time will be equivalent to 16-15=1 clock at a pixel where the discharging operation is performed at the timing which accords with the third discharge control having the largest amount of delay.

As one example, an operation with an enable signal ENBL given from the controller 7 as shown in Fig. 2 is hereinafter specifically described, with the focus on the pixel p3. Pixel p3 is the third pixel when counted from the pixel p0. Accordingly, the readout switch 12 of the pixel p3 is turned on when the enable signal ENBL is set to the high level at phase #1 after the elapse of 3x4=12 clocks from when the signal was read from the pixel p0. By this operation, the signal charges accumulated until that point are extracted to the signal output line 2 and sent through this line 2 to the outside. Simultaneously with the readout of the signal charges, the potential of the photodiode 11 in the pixel p3 is reset, after which the accumulation of the electric charges produced by photoelectric conversion from the incident light is immediately resumed.

At phase #2 which is five clocks later than the previously described signal-readout operation, a command value of logical "1" for turning on the discharge switch 13 at the timing which accords with the first discharge control (line Q1 in Fig. 2) is fed from the phase identification circuit 110 to the logical gate circuit 5 assigned to the pixel p3. However, this command value is blocked by the AND gate 52 and cannot reach the pixel p3, since the enable signal ENBL at this point is maintained at the low level. Accordingly, the charge accumulation in the photodiode 11 of the pixel p3 is continued.

Next, at phase #3 which is 10 clocks later than the previously described signal-readout operation, a command value of logical "1" for turning on the discharge switch 13 at the timing which accords with the second discharge control (line Q2 in Fig. 2) is fed from the phase identification circuit 110 to the logical gate circuit 5 assigned to the pixel p3. In this phase, when the enable signal ENBL is switched to the high level by the controller 7, the command value passes through the AND gate 52 and reaches the pixel p3. As a result, the discharge switch 13 of the pixel p3 is turned on, causing the electric charges accumulated in the photodiode 11 until that point to be entirely drained through the discharge line 3 to the outside. Thus, the potential of the photodiode 11 is once more reset. Immediately after this, when the discharge switch 13 is turned off once more, the charge accumulation in the photodiode 11 of the pixel p3 is resumed from the reset state.

Furthermore, at phase #4 which is 15 clocks later than the previously described signal-readout operation, a command value of logical "1" for turning on the discharge switch 13 at the timing which accords with the third discharge control (line Q3 in Fig. 2) is fed from the phase identification circuit 110 to the logical gate circuit 5 assigned to the pixel p3. Once again, this command value is blocked by the AND gate 52 and cannot reach the pixel p3, since the enable signal ENBL is maintained at the low level. Accordingly, the charge accumulation in the photodiode 11 of the pixel p3 is continued.

Then, after the elapse of the readout period T=16 clocks from the point of the previous signal-readout operation, the readout switch 12 is once more turned on to read signal charges accumulated in the photodiode 11 of the pixel p3. The amount of signal charges read this time is the result of the accumulation which began at the intermediate point when the previously accumulated electric charges were entirely drained at phase #3. The charge accumulation time corresponds to 6 clocks. Thus, in the present example, at each pixel where the discharging operation is performed at the timing which accords with the second discharge control, the charge accumulation time is reduced to the length corresponding to 6 clocks, which is 0.375 times the readout period T.

In the example shown in Fig. 2, the discharging operation is not performed at any timing for the two pixels p0 and p1. Therefore, the charge accumulation time for these two pixels has a length corresponding to 16 clocks, which is equal to the readout period T. As for the pixel p2, the discharging operation is performed at the timing of phase #2 according to the first discharge control, and therefore, the charge accumulation time has a length corresponding to 11 clocks. Thus, for each pixel, there are three possible choices of the charge accumulation time in addition to the maximum value, i.e. the readout period T. The choice of which pixel should be given which of the possible values of the charge accumulation time, can be made through the timing of switching the enable signal ENBL to the high level.

It is evident that a similar operation can be performed even if the number N of pixels, which was assumed to be four in Fig. 2, is increased.

Thus, in the linear image sensor of the present embodiment, it is possible to set a charge accumulation time shorter than the readout period T in an arbitrary number of pixels located at arbitrary positions. In a spectrophotometer as shown in Fig. 4, the positions on the linear image sensor 108 of the pixels which receive a bright line having an extremely high level of intensity among the components of light emitted from the light source 100 are fixed. Therefore, for example, it is possible to set an extremely short charge accumulation time at those pixels to prevent them from being saturated with electric charges. A signal with an adequately high SN ratio can be obtained at every pixel (or at every wavelength), while preventing the pixel from being saturated with electric charges, by previously investigating the intensity of light received by each pixel without passing through the liquid sample 104 and then finely adjusting the charge accumulation time at each pixel according to the intensity distribution.

### [Second Embodiment]

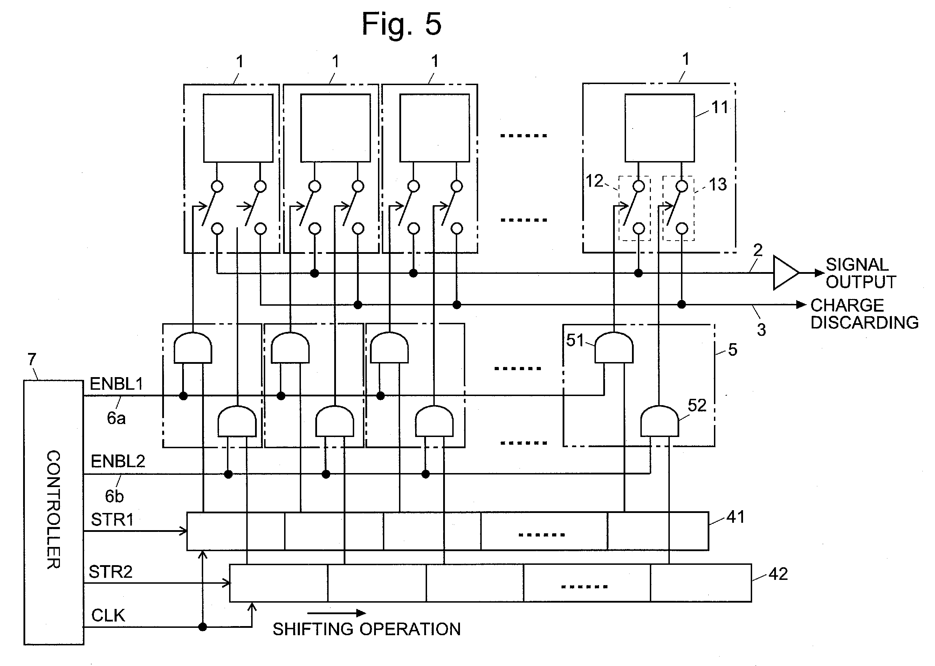

A linear image sensor and its driving method according to the second embodiment different from the first embodiment is hereinafter described using Figs. 5 and 6. Fig. 5 is a configuration diagram showing the main components of the linear image sensor according to the second embodiment, and Fig. 6 is a model diagram illustrating the driving method for controlling the charge accumulation time in the linear image sensor of the second embodiment. The components identical or corresponding to those of the first embodiment are denoted by the same numerals.

The linear image sensor of the second embodiment is completely identical to that of the first embodiment in terms of the configuration of each individual pixel 1. A difference exists in that the number of shift registers is increased in exchange for the decreased number of stages of each shift register. It should be noted that the second embodiment is configured to realize only one choice of the charge accumulation time that is shorter than the readout period T. To this end, there are two N-stage shift registers (41 and 42). The first shift register 41 is used to scan the readout switches 12, while the second shift register 42 is used to scan the discharge switches 13. The clock signal CLK supplied from the controller 7 is common to both shift registers 41 and 42, whereas the start signals STR1 and STR2 are independent from each other. The enable signal is also separated into two, one for the readout control and the other for the discharge control.

The operation for controlling the charge accumulation time is also approximately the same as in the first embodiment: After the start signal STR1 for the readout control is inputted into the first shift register 41, the start signal STR2 for the discharge control is inputted into the second shift register 42 with a predetermined amount of delay time. This delay in time determines the length of the charge accumulation time shorter than the readout period T. As shown in Fig. 6, when the enable signal ENBL2 is switched to the high level at a timing when a command value of logical "1" for turning on the switch 13 is present at the output of the flip flop assigned to the pixel p in the second shift register 42, the discharge switch 13 of that pixel becomes turned on, whereby the electric charges accumulated in the photodiode 11 until that point are drained. Therefore, the charge accumulation time becomes shorter than the readout period T.

In the present example, the charge accumulation time at an arbitrary pixel can also be increased to k times the readout period T (where k is an integer equal to or greater than two) by appropriately omitting the readout operation performed according to the readout period T. In the example shown in Fig. 6, the charge accumulation time at the pixel q is increased to two times the readout period T by omitting the readout operation one time by maintaining the enable signal ENBL1 at the low level at a timing when a command value of logical "1" for turning on the switch 12 is present at the output of the flip flop assigned to the pixel q in the first shift register 4a. Thus, the charge accumulation time cannot only be shorter than the readout period T but also longer than this period. This also holds true in the first embodiment.

Thus, in the linear image sensor according to the present invention, it is possible to allot an optimum or nearly optimum charge accumulation time to any of the pixels forming the linear CMOS image sensor, by combining a shift register having [number of pixels] × [number of phases necessary for control] stages with logical gate circuits, or by combining [number of phases necessary for control] shift registers each having [number of pixels] stages with logical gate circuits. The number of phases necessary for control in the present context is the sum of the number of readout controls and that of the discharge controls. This number is "four" in the first embodiment and "two" in the second embodiment.

It should be noted that the previously described embodiments are mere examples of the present invention, and any change, modification or addition appropriately made within the spirit of the present invention will evidently fall within the scope of claims of the present application.

### REFERENCE SIGNS LIST

- 1: Pixel
- 100: Light Source
- 11: Photodiode
- 12: Readout Switch
- 13: Discharge Switch
- 2: Signal Output Line
- 3: Discharge Line
- 4, 41, 42: Shift Register
- 4a, 4b, 4c, 4d: Flip Flop
- 5: Logical Gate Circuit
- 51, 52: AND Gate
- 53: Three-Input OR Gate
- 6: Enable Signal Line
- 7: Controller
- 110: Phase Identification Circuit
- 111a-111d: Phase Identification Signal Line

## Claims

1. A linear image sensor comprising:
a) N pixels arrayed in a one-dimensional form, each pixel having: a signal-generating section including a photoelectric conversion element; a readout switch provided for the signal-generating section between the signal-generating section and a signal output line which will be mentioned later; and a discharge switch provided for the signal-generating section between the signal-generating section and a discharge line which will be mentioned later;
b) a signal output line common to all the pixels, for extracting signals obtained in the N pixels;
c) a discharge line for discarding electric charges obtained in the N pixels; and
d) a drive controller for commanding an operation of temporarily turning on the readout switch and an operation of temporarily turning on the discharge switch, these two operations being commanded for each pixel and independently from each other, the drive controller turning on the readout switches of the pixels during mutually different periods of time and commanding the turning on/off of the readout switch and the discharge switch of each pixel after determining, for each pixel, whether or not the discharge switch in the pixel should be turned on, or specifying, for each pixel, a timing of turning on the discharge switch in the pixel, within a period of time from a point of turning on the readout switch at the pixel concerned to a next point of turning on the same readout switch.

2. The linear image sensor according to claim 1, wherein:
the drive controller commands the turning on/off of the readout switch and the discharge switch of each pixel in such a manner that, within a predetermined readout period, the readout switches in the N pixels are sequentially turned on, once for each pixel, while the discharge switches in at least some of the pixels are temporarily turned on in a predetermined order.

3. The linear image sensor according to claim 1 or 2, wherein:
the drive controller further includes: at least one address scan circuit for selecting each pixel or the readout switch and the discharge switch in each pixel; and N logical gate circuits provided for the N pixels, respectively, with each logical gate circuit allowing or preventing a passage of a command value from the address scan circuit according to an enable signal.

4. The linear image sensor according to claim 3, wherein:
the address scan circuit includes one M×N-stage shift register (where M is an integer equal to or greater than two) which completes a scan of all stages within a predetermined readout period T;
the logical gate circuit provided for each of the N pixels receives, as inputs, an output from one stage of the M×N-stage shift register, the enable signal, and M pieces of phase identification signals;
the logical gate circuit includes:
a phase identification circuit with a plurality of outputs, for finding a phase at which the output of the shift register is valid among M phases defined by the M pieces of phase identification signals, and for outputting a valid value only at each phase found;
a first gate circuit for receiving, as inputs, one output of the phase identification circuit and the enable signal, and for allowing the passage of the value received from the phase identification circuit when the enable signal has a valid value; and
a second gate circuit for receiving, as inputs, outputs of the phase identification circuit exclusive of the aforementioned one output and the enable signal, and for allowing a passage of the outputs of the phase identification circuit corresponding to the M-1 phases exclusive of the signal of the phase sent to the first gate circuit when the enable signal has a valid value; and
each pixel is configured so that the output of the first gate circuit drives the readout switch of the pixel while the output of the second gate circuit drives the discharge switch of the pixel.

5. The linear image sensor according to claim 3, wherein:
the address scan circuit includes M pieces of N-stage shift registers (where M is an integer equal to or greater than two) which complete a scan of all stages corresponding to the N pixels within a predetermined readout period T;
the logical gate circuit provided for each of the N pixels includes M gate circuits, with each of the M gate circuits receiving, as inputs, an output from one stage of one N-stage shift register among the M pieces of the N-stage shift registers and the enable signal, and allowing a passage of a value of the input different from the enable signal when the enable signal has a valid value; and
each pixel is configured so that L outputs among outputs of the M gate circuits (where L is an integer equal to or greater one and equal to or less than M) drive the readout switch of the pixel while the remaining M-L outputs drive the discharge switch of the pixel.

6. A method for driving the linear image sensor according to claim 4, comprising:
inputting a clock signal with a period Δt equal to T/(M+N) and a start signal for initiating a scan into the M×N-stage shift register; and
inputting the start signal M times during the readout period T, the M start signals having different delay times and respectively synchronized with different phases where a phase #m represents a period of length Δt during which the m-th phase identification signal (m=1, ..., M) is providing a valid value with the period of length Δt among the M phase identification signals continuously generated for any one of the N pixels, with one phase identification signal generated for each pulse of the clock signal.

7. A method for driving the linear image sensor according to claim 5, comprising:
inputting a common clock signal with a period Δt equal to T/N into all the M shift registers and inputting a start signal for initiating a scan of each shift register into each of the M shift registers,
where at least one of the M start signals is inputted with a timing different from the other start signals.
